# EUROPEAN PATENT SPECIFICATION

(11) **EP 0 425 136 B1**
(45) Date of publication and mention of the grant of the patent: **22.09.1993**
(21) Application number: 90311155.7
(22) Date of filing: 11.10.1990
(51) Int. Cl.: B23K 26/18, B23K 26/00

(54) **Mask and method for the production of at least one groove, rib or different intensity strip in or on a surface**
Maske und Verfahren für die Produktion von wenigstens einer Nut, Rippe oder Streifen verschiedener Intensität in oder auf einer Oberfläche
Masque et méthode pour la production d'au moins une rainure, une nervure ou une bande d'une intensité différente dans ou sur une surface

(30) Priority: 21.10.1989 GB 8923754
(43) Date of publication of application: 02.05.1991
(73) Proprietor: BRITISH AEROSPACE PUBLIC LIMITED COMPANY, Farnborough, Hants. GU14 6YU (GB)
(72) Inventor: Lloyd, Mark Llewellyn, Sowerby Research Centre, Filton, Bristol BS12 7QW (GB)
(74) Representative: Rooney, Paul Blaise

(56) References cited:
- FR-A- 2 546 787
- US-A- 4 081 653

## Description

This invention relates to a apparatus and a method for the production of at least one groove, rib or different intensity strip in or on a surface using a mask and is particularly, but not exclusively, concerned with such apparatus and method for the production of grooves in a surface by laser.

Grooves may be formed in a substantially planar surface, either in a paint layer on a metal substrate or in an unpainted metal surface by subjecting the surface to a directed beam of laser energy radiation. The laser beam impinges on the surface at right angles thereto and the surface and beam are moved relative to one another, so that the beam removes material from the surface along a path which is generally groove shaped. One of the problems of this technique is the difficulty of controlling the shape of the groove over its cross section, that is its profile. The profile of a groove produced in this way is not easily controlled and may not be suitable for all applications.

Control of the form of the groove over its cross section may be improved by using a mask provided with a series of side by side slot-like apertures therein each conforming to the shape in plan desired for a groove to be produced. Such a mask is located between the laser beam source, which may include a beam focusing lens and the surface. The mask conveniently is fixed relative to the source and lens, so that if the beam source and lens are moveable relative to the surface, the mask moves with the beam source and lens.

However even with such a mask the cross sectional shape of the groove so produced cannot be controlled or varied reliably from the usual V shaped cross section produced. Some control over the cross sectional shape of the groove produced may be achieved by variation of the intensity of the laser beam during relative movement of the mask and surface, but this is difficult to control.

The same problem exists in trying to produce by electromagnetic radiation means a strip having a controlled density across its width on a photographic emulsion layer. Control of the density of the strip in the region of its edges is particularly difficult to effect and similarly control of the depth of a groove or height of a rib at its side edges is likewise difficult to effect.

There is thus a need for a generally improved mask apparatus and method, using a mask for the production of at least one groove, rib or different intensity strip in or on a surface which is both more accurate and simpler to control.

According to a first aspect of the present invention there is provided an apparatus for the production of at least one groove, rib or different intensity strip in or on a surface, comprising a mask made of sheet material and having at least two rows of laterally spaced, substantially triangular in plan apertures therethrough, with the apertures of one row facing in the opposite direction to those of the other row of said at least two rows and being interspersed apertures, so that one aperture lies between two adjacent apertures with apices of the apertures adjoining bases of the apertures; a source of material deposition for rib production or a source of material removal for groove production, and means for causing relative motion between the mask and said surface.

According to a further aspect of the present invention there is provided a method for the production of at least one groove, rib or different intensity strip in or on a surface, including the steps of positioning a mask and the surface face to face, with or without a spacing therebetween, which mask is made of sheet material and has at least two rows of laterally spaced, substantially triangular in plan apertures therethrough, with the apertures of one row facing in the opposite direction to those of the other row of said at least two rows and being interspersed with apertures, so that one aperture lies between two adjacent apertures with apices of the apertures adjoining bases of the apertures, applying a source of material deposition for rib production, a source of material removal for groove production or a source of intensity variation for strip production, to the side of the mask remote from said surface, to deposit material on, remove material from or vary the intensity on said surface through each said aperture and causing relative motion between the surface on the one hand and the mask on the other hand in the general direction of the aperture sides, so that the height and cross section of said rib material deposition on the surface, the depth and cross section of said groove material removal from the surface, or the variation in intensity across the width of a strip on the surface, is proportional to the length of each said aperture side, the change in width of each said aperture with length and the speed of relative movement between each said aperture and said surface.

For a better understanding of the present invention and to show how the same may be carried into effect, reference will now be made, by way of example to the accompanying drawing, in which:
Figure 1 is a plan view of a first form of mask for use according to the invention for the production of at least one groove, rib or different intensity strip in or on a surface,
Figure 2 is a plan view of a second form of mask for use according to the invention, and
Figure 3 is a plan view of a third form of mask for use according to the invention.

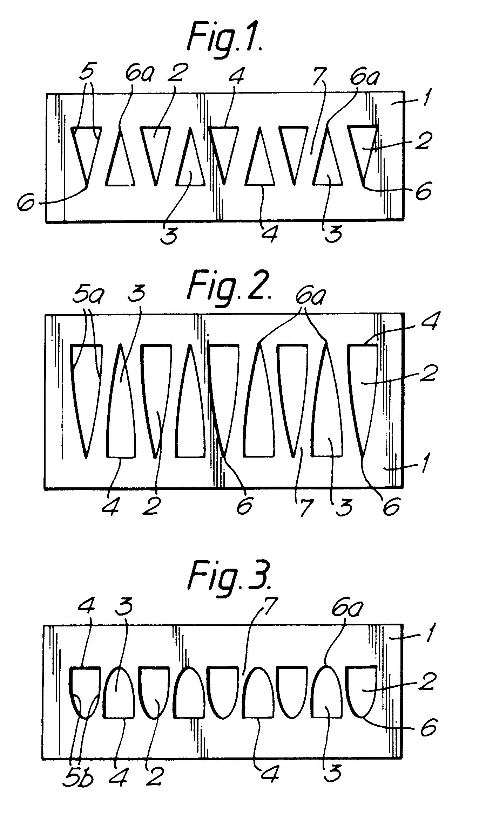

A mask is shown in the accompanying drawings which is suitable for use with the apparatus and method of the present invention for the production of at least one groove, rib or different intensity strip in or on a surface. The mask 1 is made of sheet material, preferably metallic or plastics, and provided with at least two rows of laterally spaced substantially triangular in plan apertures 2,3 therethrough as shown in Figures 1 to 3. As also shown in Figures 1, 2 and 3 the apertures 3 of the one row, face in the opposite direction to the apertures 2 of the other row and are interspersed with the first row apertures 2 so that one second row aperture 3 lies between two adjacent apertures 2 of the first row. The or each aperture 2 or 3 is substantially triangular in plan having a base 4 and two sides 5.

As can be seen from the Figures preferably the or each aperture 2 and 3 has two sides 5 longer than its base 4. In the Figure 1 the two sides 5 are straight.

However in the Figure 2 example the two sides 5a are curved in plan whilst in the Figure 3 example the two sides 5b are curved more strongly in plan. Otherwise the examples of Figures 1,2 and 3 are similar and like features therein have been given like references.

As can be seen from Figures 1, 2, and 3 the apertures 2 of the first row extend side by side with their bases 4 at one end of the row and with their apices 6 at the opposite end of the row. The apertures 3 of the second row extend side by side with their bases 4 at one end of the second row and with their apices 6a at the other end of the second row. The bases 4 of one row of apertures adjoins the apices 6 or 6a of the other row of apertures.

Basically the method and apparatus of the present invention uses the mask 1 to transfer a one dimensional intensity profile is transferred into a two dimensional binary profile. This two dimensional profile is automatically converted into the required groove, rib or strip profile as the mask is scanned across the substrate surface. Thus in the method of the present invention for the production of at least one groove, rib or different intensity strip in or on a surface using the apparatus of the invention, the mask 1 and the surface are positioned face to face, with or without a spacing therebetween. A source of material deposition for rib production, a source of material removal for groove production or a source of intensity variation for strip production is applied to the side of the mask 1 remote from said surface, to deposit material on, remove material from or vary the intensity on said surface through each aperture 2 and 3 and relative motion is brought about between the surface on the one hand and the mask 1 on the other hand in the general direction of the aperture sides 5, 5a and 5b. In this way the height and cross section of the rib material deposition on the surface, the depth and cross section of the groove material removal from the surface or the variation in intensity across the width of strip on the surface is proportional to the length of each aperture side 5, 5a or 5b, the change in width of each aperture 2, 3 with length and the speed of relative movement between each aperture 2, 3 and said surface.

The source of material deposition conveniently is a spray of molten metal, plastics or paint and the surface so treated may be made of metal and/or plastics. Alternatively the source of material removal may be a laser or a spray of etching fluid and the surface so treated may be paint, metal or plastics.

Yet a further alternative is to use a source of intensity variation in the form of a beam of electromagnetic radiation to act on a surface which comprises a photographic film emulsion layer.

By appropriately choosing the shape in plan of the aperture sides 5, 5a and 5b it is possible to control the cross sectional shape more accurately of the rib, groove or strip produced. Additionally by so nesting the rows of apertures such that the apertures 3 are interspersed with the apertures 2 it is possible to provide a strong mask 1 but a mask 1 which will produce ribs, grooves or strips which are very close together. This is a function of the substantially triangular shape of the apertures and enables the nesting to be carried our whilst leaving substantial support ribs 7 between adjacent apertures.

The principle underlying the apparatus and method of the invention is that with the shaped apertures in the mask 1 the surface under the greater width portion of each aperture is impinged by the laser for a short period of time whilst the remaining narrower width areas receive a proportionally greater amount of the laser beam (i.e. for a larger period of time) and have a proportionally greater amount of material removal.

Preferably the mask 1 is aligned parallel to the surface during material deposition, material removal or intensity variation but alternatively the mask 1 may be tilted with respect to the surface with the tilt being either in the direction of relative movement between the mask 1 and surface or transverse thereto to provide for greater control of the degree of material removal at the sides 5, 5a or 5b of the mask.

A particularly favoured use of the apparatus and method of the invention is for the production of riblets in a paint or metal surface of an aircraft by laser removal of paint or metal between the riblet areas. Such riblets decrease surface drag of the aircraft under certain conditions.

## Claims

1. An apparatus for the production of at least one groove, rib or different intensity strip in or on a surface, comprising a mask (1) made of sheet material and having at least two rows of laterally spaced, substantially triangular in plan apertures (2,3) therethrough, with the apertures (3) of one row facing in the opposite direction to those of the other row (2) of said at least two rows and being interspersed apertures (2), so that one aperture (3) lies between two adjacent apertures (2) with apices (6) of the apertures (3) adjoining bases (4) of the apertures (2); a source of material deposition for rib production or a source of material removal for groove production, and means for causing relative motion between the mask (1) and said surface.

2. Apparatus according to claim 1 wherein each aperture (2,3) has two sides (5a, 5b) which are curved in plan view.

3. A method for the production of at least one groove, rib or different intensity strip, in or on a surface, including the steps of positioning a mask (1) and the surface face to face, with or without a spacing therebetween, which mask is made of sheet material and has at least two rows of laterally spaced, substantially triangular in plan apertures (2,3) therethrough, with the apertures (3) of one row facing in the opposite direction to those of the other row (2) of said at least two rows and being interspersed with apertures (2), so that one aperture (3) lies between two adjacent apertures (2) with apices (6) of the apertures (3) adjoining bases (4) of the apertures (2), applying a source of material deposition for rib production, a source of material removal for groove production or a source of intensity variation for strip production, to the side of the mask remote from said surface to deposit material on, remove material from or vary the intensity on said surface through each said aperture (2,3) and causing relative motion between the surface on the one hand and the mask (1) on the other hand in the general direction of the aperture sides (5, 5a, 5b), so that the height and cross section of said rib material deposition on the surface, the depth and cross section of said groove material removal from the surface, or the variation in intensity across the width of a strip on the surface, is proportional to the length of each said aperture side, (5, 5a, 5b) the change in width of each said aperture (2, 3) with length and the speed of relative movement between each said aperture (2, 3) and said surface.

4. A method according to Claim 3, wherein the source of material deposition is a spray of molten metal, plastics or paint and wherein the surface is metal and/or plastics.

5. A method according to Claim 3, wherein the source of material removal is a laser or a spray of etching fluid and wherein the surface is paint, metal and/or plastics.

6. A method according to Claim 3, wherein the source of intensity variation is a beam of electromagnetic radiation and wherein the surface is photosensitive material or a photographic film emulsion layer.

7. A method according to any one of Claims 3 to 6, in which the mask (1) is parallel to the surface during material deposition, material removal or intensity variation.

8. A method according to any one of Claims 3 to 6, in which the mask (1) is tilted with respect to the surface, with the tilt being either in the direction of relative movement between the mask (1) and surface or transverse thereto.

## Patentansprüche

1. Vorrichtung zur Erzeugung von wenigstens einer Nut, einer Rippe oder eines Streifens verschiedener Intensität in oder auf einer Oberfläche, mit einer Maske (1) aus Blattmaterial, die wenigstens zwei Reihen von seitlich im bestand zueinander angeordneten, im wesentlichen im Grundriß dreieckigen Öffnungen (2, 3) besitzt, wobei die Öffnungen (3) der einen Reihe in eine Richtung weisen, die der Richtung, in der die andere Reihe (2) der wenigstens zwei Reihen weist, entgegengesetzt ist, wobei die Öffnungen (2) so ineinander geschachtelt sind, daß eine Öffnung (3) jeweils zwischen zwei benachbarten Öffnungen (2) zu liegen kommt und die Scheitel (6) der Öffnungen (3) benachbart zu den Basisrändern (4) der Öffnungen (2) liegen, und wobei eine Quelle einer Metallablagerung zur Rippenproduktion oder eine Quelle zur Materialabfuhr zur Nutproduktion und Mittel vorgesehen sind, um eine Relativbewegung zwischen der Maske (1) und der Oberfläche zu erzeugen.

2. Vorrichtung nach Anspruch 1, bei welcher jede Öffnung (2, 3) zwei Seiten (5a, 5b) aufweist, die in Grundrißansicht gekrümmt sind.

3. Verfahren zur Erzeugung wenigstens einer Nut, Rippe oder eines Streifens verschiedener Intensität in oder auf der Oberfläche, mit den folgenden Schritten: es wird eine Maske (1) flächenmäßig auf eine Oberfläche mit oder ohne Abstand dazwischen gebracht; die Maske besteht aus Blattmaterial und weist wenigstens zwei Reihen von seitlich im Abstand zueinander liegenden, im Grundriß im wesentlichen dreieckigen Öffnungen (2, 3) auf, wobei die Öffnungen (3) der einen Reihe in eine Richtung weisen, die der Richtung entgegengesetzt ist, in die die andere Reihe (2) der wenigstens zwei Reihen weist; die Öffnungen (3) wechseln mit den Öffnungen (2) ab, so daß jeweils eine Öffnung (3) zwischen zwei benachbarten Öffnungen (2) liegt und die Scheitel (6) der Öffnungen (3) benachbart zu den Basiskanten (4) der Öffnungen (2) liegen; es wird eine Quelle für Materialablagerung zur Rippenproduktion, eine Quelle zur Materialentfernung für die Nuterzeugung oder eine Quelle sich ändernder Intensität zur Streifenproduktion auf jener Seite der Maske angeordnet, die von der Oberfläche entfernt liegt, auf der Material aufgetragen, Material abgetragen oder die Intensität auf der Oberfläche durch die Öffnungen (2, 3) geändert wird; und es wird eine Relativbewegung zwischen der Oberfläche einerseits und der Maske (1) andererseits allgemein in Richtung der Seiten (5, 5a, 5b) hervorgerufen, so daß die Höhe und der Querschnitt der Rippenmaterialablagerung auf der Oberfläche, die Tiefe und der Querschnitt der Nutmaterialentfernung von der Oberfläche oder eine Intensitätsänderung über die Breite eines Streifens der Oberfläche proportional ist der Länge jeder Seite (5, 5a, 5b) der Öffnung, der Änderung in der Breite jeder Öffnung (2, 3) mit der Länge und der Geschwindigkeit der Relativbewegung zwischen jeder Öffnung (2, 3) und der Oberfläche.

4. Verfahren nach Anspruch 3, bei welchem die Quelle der Materialablagerung eine Spritzvorrichtung für geschmolzenes Metall, für Plastik oder Farbe ist und wobei die Oberfläche aus Metall und/oder Plastikmaterial besteht.

5. Verfahren nach Anspruch 3, bei welchem die Quelle der Materialentfernung ein Laser oder eine Sprühvorrichtung für eine Ätzflüssigkeit ist und wobei die Oberfläche Farbe, Metall und/oder Plastik ist.

6. Verfahren nach Anspruch 3, bei welchem die Quelle der Intensitätsänderung ein elektromagnetischer Strahl ist und die Oberfläche aus lichtempfindlichem Material oder einer photographischen Filmemulsionsschicht besteht.

7. Verfahren nach den Ansprüchen 3 bis 6, bei welchem die Maske während der Materialablagerung, der Materialentfernung oder der Intensitätsänderung parallel zur Oberfläche liegt.

8. Verfahren nach einem der Ansprüche 3 bis 6, bei welchem die Maske (1) gegenüber der Oberfläche geneigt ist, wobei die Neigung in einer der beiden Richtungen der Relativbewegung zwischen Maske (1) und Oberfläche oder quer hierzu erfolgt.

## Revendications

1. Appareil pour la fabrication d'au moins une rainure, nervure ou bande d'intensité différente dans ou sur une surface, comportant un masque (1) réalisé dans une matière en feuille et ayant au moins deux rangées d'ouvertures latéralement espacées et de forme en plan sensiblement triangulaire (2, 3), avec les ouvertures (3) d'une rangée dirigées dans le sens opposé a celles de l'autre rangée (2) desdites deux rangées et qui sont intercalées avec les ouvertures (2), de telle sorte qu'une ouverture (3) s'étend entre deux ouvertures (2) adjacentes avec des sommets (6) des ouvertures (3) adjacents aux bases des ouvertures (2); une source de dépôt de matière pour la fabrication de nervure ou une source d'enlèvement de matière pour la fabrication de rainure, et des moyens destinés à entraîner un déplacement relatif entre le masque (1) et ladite surface.

2. Appareil selon la revendication 1, dans lequel chaque ouverture (2, 3) a deux côtés (5a, 5b) qui sont courbes vus an plan.

3. Procédé de fabrication d'au moins une rainure, nervure ou bande d'intensité différente dans ou sur une surface, comprenant les étapes de positionnement d'un masque (1) et de la surface face à face, avec ou sans espace entre eux, lequel masque est réalisé dans une matière en feuille et est pourvu d'au moins deux rangées d'ouvertures latéralement espacées et de forme en plan sensiblement triangulaire (2, 3), avec les ouvertures (3) d'une rangée dirigées dans le sens opposé à celles de l'autre rangée (2) desdites deux rangées et qui sont intercalées avec les ouvertures (2), de telle sorte qu'une ouverture (3) s'étend entre deux ouvertures (2) adjacentes avec des sommets (6) des ouvertures (3) adjacents aux bases des ouvertures (2), d'application d'une source de dépôt de matière pour la fabrication de nervure, d'une source d'enlèvement de matière pour la fabrication de rainure ou d'une source de variation d'intensité pour la fabrication de bande, sur le côté du masque éloigné de ladite surface afin de déposer de la matière sur, d'enlever de la matière dans ou de modifier l'intensité sur ladite surface à travers chaque ouverture (2, 3) et de déplacament relatif entre la surface d'une part et le masque (1) d'autre part dans la direction générale des côtés d'ouverture (5, 5a, 5b) de telle sorte que la hauteur et la section dudit dépôt de matière de nervure sur la surface, la profondeur et la section dudit enlèvement de matière de rainure de la surface, ou la variation d'intensité sur la largeur d'une bande sur la surface est proportionnelle à la longueur de chaque côté d'ouverture (5, 5a, 5b), au changement de largeur de chaque ouverture (2, 3) et à la longueur et la vitesse de déplacement relatif entre chaque ouverture (2, 3) et ladite surface.

4. Procédé selon la revendication 3, dans lequel la source de dépôt de matière est une pulvérisation de métal fondu, de matière plastique ou de peinture et dans lequel la surface est on métal et/ou en matière plastique.

5. Procédé selon la revendication 3, dans lequel la source d'enlèvement de matière est un laser ou une pulvérisation de fluide de gravure et dans lequel la surface est de la peinture, du métal ou de la matière plastique.

6. Procédé selon la revendication 3, dans lequel la source de variation d'intensité est un faisceau de rayonnement électromagnétique et dans lequel la surface est une matière photosensible ou une couche d'émulsion de film photographique.

7. Procédé selon l'une quelconque des revendication 3 à 6, dans lequel le masque (1) est parallèle à la surface pendant le dépôt de matière, l'enlèvement de matière ou la variation d'intensité.

8. Procédé selon l'une quelconque des renvendication 3 à 6, dans lequel le masque (1) est incliné par rapport à la surface, l'inclinaison étant dans la direction de déplacement relatif entre le masque (1) et la surface, ou bien transversale à celui-ci.
